# EUROPÄISCHE PATENTSCHRIFT

(11) **EP 3 082 170 B1**
(45) Veröffentlichungstag und Bekanntmachung des Hinweises auf die Patenterteilung: **17.02.2021**
(21) Anmeldenummer: 16000853.8
(22) Anmeldetag: 15.04.2016
(51) Int. Cl.: H01L 31/0304, H01L 31/167, H01L 25/16

(54) **STAPELFÖRMIGER OPTOKOPPLERBAUSTEIN**
STACKED OPTOCOUPLER MODULE
COMPOSANT OPTOCOUPLEUR EMPILÉ

(30) Priorität: 17.04.2015 EP 15001126
(43) Veröffentlichungstag der Anmeldung: 19.10.2016
(73) Patentinhaber: AZUR SPACE Solar Power GmbH, 74072 Heilbronn (DE)
(72) Erfinder: Guter, Wolfgang, 70190 Stuttgart (DE); Fuhrmann, Daniel, 74081 Heilbronn (DE); Wachter, Clemens, 74348 Lauffen am Neckar (DE)
(74) Vertreter: Koch Müller Patentanwaltsgesellschaft mbH

(56) Entgegenhaltungen:
- DD-A5- 287 356
- DE-A1- 4 005 835
- DE-A1- 19 638 194
- JP-A- H0 368 177
- JP-A- H0 645 636
- US-A- 4 127 862
- US-A- 4 996 577
- US-A1- 2003 106 580
- US-A1- 2006 048 811
- US-A1- 2014 284 629

## Beschreibung

Die Erfindung betrifft einen stapelförmigen Optokopplerbaustein.

Aus der DE 100 11 258 A1, der US 2014 004 234 4 A1, der US 2014 021 208 5 A1, der DE 33 17 054 A1, der US 2006 006 095 5 A1, der US 4 127 862, der DE 3 633 181 A1 und der US 4 996 577 sind unterschiedliche Optokopplerbausteine bekannt. Des Weiteren sind aus der US 4 766 471 A, der US 2006 / 0 0481 811 A1, der US 2008 / 0173 879 A1, der JP 2015 / 029037 A und der JP 58 - 7886 weitere Optokopplerbauelemente bekannt. Aus der DE 196 38 194 A1, der US 2014 / 028 462 9 A1, der US 2003 / 106 480 A1, der US 4 996 577 A1, der JP H06 45636, der DD 287 356 A5 sind weitere optische Bauelemente bekannt.

Vor diesem Hintergrund besteht die Aufgabe der Erfindung darin, eine Vor-richtung anzugeben, die den Stand der Technik weiterbildet.

Die Aufgabe wird durch einen stapelförmigen Optokopplerbaustein mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein stapelförmiger Optokopplerbaustein bereitgestellt, aufweisend einen Senderbaustein mit einem Sendebereich, wobei der Sendebereich eine Oberfläche aufweist, und einen Empfängerbaustein mit einem Empfangsbereich, wobei der Empfangsbereich eine Oberfläche aufweist, und einen plattenförmigen elektrischen Isolator, wobei der Isolator zwischen dem Senderbaustein und dem Empfängerbaustein ausgebildet ist, und der Senderbaustein und der Empfängerbaustein und der Isolator stapelförmig aufeinander angeordnet sind und der Isolator eine Oberseite und eine Unterseite aufweist. Der Senderbaustein und der Empfängerbaustein sind galvanisch voneinander getrennt, jedoch miteinander optisch gekoppelt, wobei der Isolator wenigstens für ein Teil der Emissionswellenlängen des Senderbausteins transparent ist, und die Schwerelinie der Oberfläche des Sendebereichs und die Schwerelinie der Oberfläche des Empfangsbereichs im Wesentlichen oder exakt zueinander parallel sind, und der Versatz zwischen den beiden Schwerelinien kleiner als die Hälfte oder kleiner als ein Zehntel oder kleiner als ein fünfzigstel der Entfernung der jeweiligen Schwerelinien zu einer Außenkante der Oberfläche des Sendebereichs oder zu einer Außenkante der Oberfläche des Empfangsbereichs ist, so dass das Licht des Senderbausteins überwiegend oder ausschließlich durch den Isolator auf den Empfängerbaustein bzw. auf die Oberfläche des Empfangsbereichs und auf den Empfangsbereich einwirkt, und der Isolators auf allen Seiten aus dem Stapel balkonförmig hervorsteht, und der Empfängerbaustein eine Anzahl N zueinander in Serie geschalteten Teilspannungsquellen aufweist, wobei N eine natürliche Zahl und N ≥ 2 ist, und die Abweichung der Teilspannungen der einzelnen Teilspannungsquellenuntereinander kleiner als 20% ist, und jede der Teilspannungsquellen eine Halbleiterdiode mit einen p-n Übergang aufweist, und zwischen jeweils zwei aufeinanderfolgenden Teilspannungsquellen eine Tunneldiode ausgebildet ist, wobei die Teilspannungsquellen und die Tunneldioden zusammen monolithisch integriert sind.

Es sei angemerkt, dass vorliegend unter dem Begriff der Schwerelinie der Oberfläche die Normale der Oberfläche an der Stelle des Schwerpunkts der Oberfläche verstanden wird. Anders ausgedrückt, sind die Schwerelinien zweier Oberflächen parallel, sind auch die jeweils zugeordneten Flächen zueinander parallel, wobei vorliegend die Oberflächen als plan oder wenigstens als nahezu plan anzusehen sind. Besteht vorliegend zwischen den beiden zueinander parallelen Schwerelinien kein Abstand, sind die beiden Flächenschwerpunkte, in stapelrichtig gesehen, genau übereinander angeordnet. Insbesondere sind die Oberflächen viereckig, vorzugsweise quadratisch und höchst vorzugsweise rechteckig ausgebildet. Es sei angemerkt, dass es sich vorliegend bei dem Begriff der Oberfläche vorzugsweise um eine plane Oberfläche insbesondere ohne Kontaktsystem oder Metallisierung handelt.

Auch versteht es sich, dass sich mittels des p-n Übergangs der Halbleiterdiode, die mittels der Einstrahlung von Licht erzeugten Elektronen-Lochpaare in der Raumladungszone getrennt werden und hierdurch die jeweilige Teilspannung erzeugt wird, wodurch die Teilspannung immer eine elektrochemische Potentialdifferenz ist. Vorzugsweise lässt sich zwischen der p und der n-Schicht auch eine intrinsische Schicht anordnen. Weiterhin versteht es sich, dass es sich bei den den p-n-Übergang ausbildenden Schichten und gegebenenfalls auch bei der intrinsischen Schicht jeweils um kristalline Schichten handelt.

Auch sei angemerkt, dass mit dem Begriff plattenförmig eine Platte mit vorzugsweise zwei parallelen und jeweils planen Plattenflächen verstanden wird, wobei die planen Flächen an der Oberseite und Unterseite der Platte ausgebildet sind.

D1 bis D4. Die Dioden D1 bis D4 weisen einen nicht dargestellten p-n Übergang auf. Zwischen jeweils zwei aufeinanderfolgenden Teilspannungsquellen ist jeweils eine Tunneldiode TD1 bis TD3 angeordnet. Die Teilspannungsquellen und die Tunneldioden TD1 bis TD3 sind zusammen monolithisch integriert

Des Weiteren liegen der Senderbaustein und der Empfängerbaustein in Form von sogenannten "Dies" vor, d.h. als ungehäuste Bausteine. Ferner weist der Senderbaustein neben dem Sendebereich auch eine Rückseite und der Empfängerbaustein neben dem Empfangsbereich auch eine Rückseite auf. Anders ausgedrückt, der Senderbaustein und der Empfängerbaustein sind als sogenannte Nacktchips oder Dies vorzugsweise jeweils unmittelbar auf bzw. unter dem Isolator angeordnet. Insgesamt liegt vorzugsweise der gesamte Stapel als ungehäustes Bauteil vor. Des Weiteren sei angemerkt, dass die Anzahl N bevorzugt gleich vier ist.

Es versteht sich, dass mit dem Begriff transparent eine geringe Absorption zumindest im Bereich der Sendewellenlänge zu verstehen ist. Vorzugsweise ist die Absorption in Bezug auf die eingestrahlte Intensität kleiner als 20% oder kleiner als 10%, höchst vorzugsweise kleiner als 5%.

Des Weiteren versteht sich, dass bei dem Empfängerbaustein, genauer gesagt bei dem Empfangsbereich die Halbleiterdioden untereinander eine im Wesentlich gleiche oder eine genau gleiche Abfolge von Halbleiterschichten mit identischen oder im Wesentlichen identischen Halbleitermaterialien aufweisen und durch die Serienschaltung der Diode die Gesamtspannung des Empfängerbausteins die Summe der Teilspannungen ist. Hierdurch lässt sich auf einfache Weise eine nahezu identische Teilspannung der jeweiligen Halbleiterdioden erzielen. Vorzugsweise weicht die Teilspannung weniger als 10 % zwischen beliebigen zwei Halbleiterdioden des Stapels voneinander ab. Ferner sei angemerkt, dass mit einem zunehmenden Abstand der einzelnen Diode von dem Isolator die Dicke des Absorptionsbereichs und hiermit die Gesamtdicke der einzelnen Diode stark, vorzugsweise exponentiell zunehmen.

Ein Vorteil ist, dass durch die neuartige stapelförmige Anordnung von mehreren monolithischen Dioden in dem Empfängerbaustein verbunden mit einer hohen Lichtempfindlichkeit sich sehr kompakte und kleine Optokopplerbausteine herstellen lassen. Insbesondere lässt sich eine direkte Einkopplung des emittierten Lichts erzielen, d.h. das Licht hat einen kurzen Weg durch den Isolator zurückzulegen, bevor das transmittierte Licht auf den Empfängerbaustein trifft.

Ein weiterer Vorteil ist, dass der Empfängerbaustein neben einer hohen Spannung, vorzugsweise oberhalb 2 V, höchst vorzugsweise oberhalb von 4 V auch einen hohen Strom oberhalb von 1 mA / cm², höchst vorzugsweise oberhalb von 100mA / cm² zur Verfügung stellt. Hierdurch lassen sich hohe Schaltgeschwindigkeiten oberhalb 10 MHz, vorzugsweise oberhalb 100 MHz erzielen.

Des Weiteren sei angemerkt, dass es vorteilhaft ist, den Sendebereich unmittelbar mit der Oberseite des Isolators und den Empfangsbereich unmittelbar mit der Unterseite des Isolators zu verbinden, so dass der Sendebereich dem Empfangsbereich zugewandt ist. Hierdurch benötigt das emittierte Licht nur den minimalen Weg zu der Empfangsfläche, d.h. zu der Oberfläche des Empfangsbereichs.

In einer alternativen Ausführung sind die Rückseite des Senderbausteins mit der Oberseite des Isolators und die Rückseite des Empfängerbausteins mit der Unterseite des Isolators verbunden. Untersuchungen haben gezeigt, dass bei Ausbildung einer Substratschicht an der Rückseite des Senderbausteins und eine Ausbildung einer Substratschicht an der Rückseite des Empfängerbausteins eine vorteilhafte stapelförmige Ausbildung gegeben ist, anders ausgedrückt die beiden Substratschichten sind vorliegend unmittelbar einander zugewandt. Mit der Ausbildung von den Substratschichten lässt sich die mechanische Stabilität des jeweiligen Bausteins erhöhen und eine zuverlässige Kontaktierung der Bausteine durchführen.

In einer anderen Ausführungsform ist der Stapel aus Senderbaustein und Isolator und Empfängerbaustein in einem gemeinsamen Gehäuse integriert.

In einer bevorzugten Weiterbildung weist der Empfängerbaustein und der Senderbaustein entlang der Stapelrichtung eine pyramidenstumpfartige Ausbildung auf, wobei der Unterschied in der Flächengröße zwischen der Unterseite des Pyramidenstumpfs und der Oberseite des Pyramidenstumpfs wenigstens 5 µm² beträgt.

Der Unterschied zwischen der Größe der Oberfläche des Sendebereichs und der Größe der Oberfläche des Empfangsbereichs ist kleiner als 20%, vorzugsweise kleiner als 10%. Untersuchungen haben gezeigt, dass es vorteilhaft ist, die Oberfläche des Empfangsbereichs entweder gleich groß wie die Oberfläche des Sendebereichs auszuführen, oder alternativ die Oberfläche des Empfangsbereichs maximal 20 % größer als die Oberfläche des Sendebereichs auszuführen.

Des Weiteren ist es bevorzugt, dass die gesamte Oberfläche des Sendebereichs und oder der Sendebereich Licht emittiert und die gesamte Oberfläche des Empfangsbereichs und der Empfangsbereich insgesamt Licht absorbiert. Hierdurch lässt sich der Wirkungsgrad des Optokopplerbausteins erhöhen. Es versteht sich, dass bei einer Emission des Lichts durch die Oberfläche des Sendebereichs eine möglichst geringe Fläche mit Kontaktmetall bedeckt ist. Nicht anders ergibt sich für den Fall der Absorption. Auch hier gilt bei einer Absorption des Lichtes durch die Oberfläche des Empfangsbereichs und in dem Empfangsbereich, dass eine möglichst geringe Fläche bzw. Flächenanteil an der gesamten Oberfläche des Empfangsbereichs mit Kontaktmetall bedeckt ist.

In einer Ausführungsform weist die Oberfläche des Sendebereichs und die Oberfläche des Empfangsbereichs eine viereckige Form auf, wobei die größte Kantenlänge des jeweiligen Vierecks kleiner als 2 mm ist. In einer Weiterbildung sind die Oberflächen des Sendebereichs und die Oberfläche des Empfangsbereichs quadratisch ausgebildet und weisen jeweils eine Grundfläche größer als 0,2 x 0,2 mm² und kleiner als 4 mm² oder kleiner als 1 mm² auf.

Des Weiteren ist es vorteilhaft, wenn die Oberflächen des Sendebereichs und die Oberfläche des Empfangsbereichs jeweils eine streifenförmige oder gitterförmige oder kleine Kontaktfläche mit einem Anteil von kleiner als 10% der gesamten Oberfläche oder eine ganzflächige Metallisierung aufweisen. Ferner weist die Rückseite des Senderbausteins als auch die Rückseite des Empfängerbausteins eine streifenförmige Kontaktfläche oder gitterförmige Kontaktfläche oder kleine Kontaktfläche mit einem Anteil von jeweils kleiner als 10% der gesamten Oberfläche oder eine ganzflächige Metallisierung auf.

In einer anderen Ausführungsform weist der Senderbaustein einen optischen Spiegel für die Wellenlänge des Senders oder eine RCLED oder einen oberflächenemittierenden Laser auf.

Untersuchungen haben gezeigt, dass der plattenförmige Isolator vorzugsweise einen Kunststoff und / oder Glas und / oder Aluminiumdioxid und / oder Epoxidharz und / oder Silikon umfasst oder aus einer derartigen Verbindung besteht. Hierbei ist auch ein mehrschichtiger Aufbau aus verschieden Materialien umfasst. Insbesondere lassen sich beispielweise die beiden Bausteine, also Senderbaustein und der Empfängerbaustein jeweils mit einer dünnen als transparente Silikonklebeschicht ausgebildeten Verbindungsschicht kraftschlüssig mit einem dünnen Glasplättchen verbinden. Es versteht sich, dass sich der Senderbaustein und der Empfängerbaustein mit dem Isolator auch mittels anderen Verbindungsmaterialien und / oder Befestigungsmittel zu einem Stapel fügen lassen.

In einer bevorzugten Weiterbildung ist die Dicke des Isolators kleiner als 0,5 mm, vorzugsweise kleiner als 0,3 mm, jedoch größer als 50µm. Es versteht sich hierbei, dass die Dicke des Isolators so gewählt ist, dass eine Durchschlagsfestigkeit zwischen dem Senderbaustein und dem Empfängerbaustein von größer als 2kV gewährleistet ist. Hierbei ist es vorteilhaft, wenn der plattenförmige Isolator auf allen Seiten aus dem Stapel um wenigstens 5 µm hervorsteht, d.h. der Isolator bildet einen umlaufenden Balkon aus, wobei der Balkon vorzugsweise maximal 250 µm hervorsteht.

In einer anderen Ausführungsform ist die Gesamtdicke des Stapels aus Senderbaustein und Isolator und Empfängerbaustein ungehäust kleiner als 3 mm, vorzugsweise kleiner als 2 mm, höchst vorzugsweise kleiner als 1,2 mm, jedoch dicker als 0,2 mm.

Zur Erhöhung des Kopplungswirkungsgrades zwischen dem Senderbaustein und dem Empfängerbaustein ist es vorteilhaft, dass die Emissionswellenlänge des Senderbausteins gleich oder um maximal 10 % kleiner als die Absorptionskante des Empfängerbausteins ist. Der Senderbaustein und der Empfängerbaustein umfassen ein III-V Material oder bestehen aus dem III-V Material. Insbesondere umfasst der Empfängerbaustein ein GaAs und / oder ein Ge-Substrat. Vorzugsweise umfasst der Empfängerbaustein ein (Al)GaAs und / oder ein InGaP und / oder ein InGaAs Material. Es sei angemerkt, dass ein in Klammer gesetztes Element, hier beispielsweise Aluminium, vorhanden sein kann, aber nicht vorhanden sein muss.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Querschnittsansicht auf eine erste erfindungsgemäße Ausführungsform mit einer Ausschnittsvergrößerung,
- Figur 2: eine Querschnittsansicht auf eine zweite erfindungsgemäße Ausführungsform,
- Figur 3a: eine Querschnittsansicht auf eine dritte erfindungsgemäße Ausführungsform mit einem Substrat,
- Figur 3b: eine Querschnittsansicht auf eine vierte erfindungsgemäße Ausführungsform mit einem Substrat,
- Figur 4: eine detaillierte Darstellung des Empfängerbausteins,
- Figur 5: eine Querschnittsansicht auf eine gehäuste Ausführungsform.

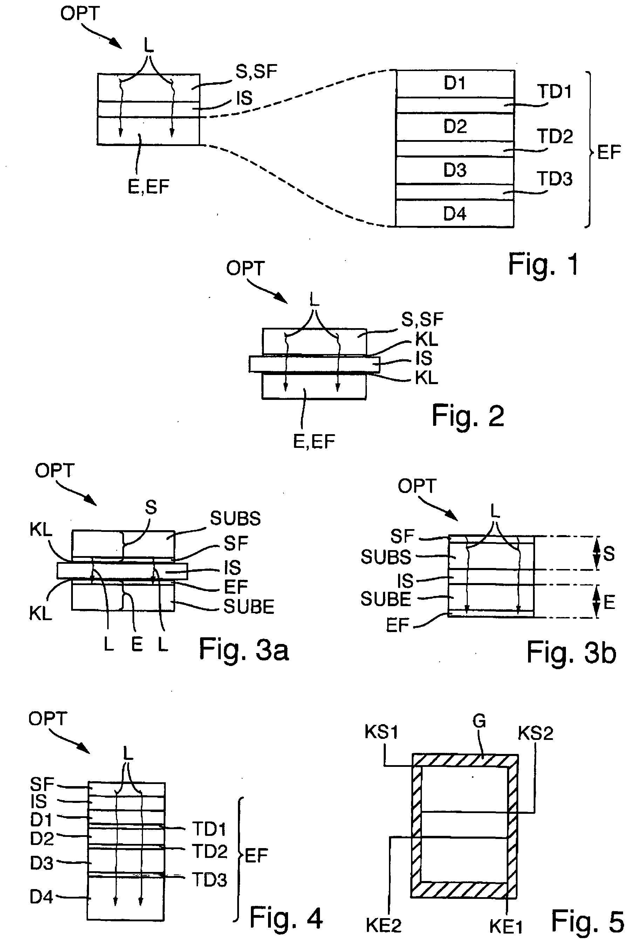

Die Abbildung der Figur 1 zeigt eine Querschnittsansicht auf eine erste erfindungsgemäße Ausführungsform eines stapelförmigen Optokopplerbausteins OPT zusammen mit einer Ausschnittsvergrößerung. Der Optokopplerbaustein OPT umfasst einen Senderbaustein S mit einem Sendebereich SF mit einer Oberfläche und einen Empfängerbaustein E mit einer Empfangsbereich EF und mit einer Oberfläche. Die Ausschnittvergrößerung zeigt einen prinzipiellen Aufbau eines Empfangsbereichs EF auf. Vorliegend ist die Flächengröße des Empfangsbereichs EF und des Empfängerbausteins E identisch mit der Flächengröße des Sendebereichs SF und des Senderbausteins S. Weiterhin umfasst der Optokopplerbaustein OPT einen plattenförmigen elektrischen Isolator IS, wobei der Isolator IS zwischen dem Senderbaustein S und dem Empfängerbaustein E ausgebildet ist.

Insgesamt ist der Senderbaustein S und der Empfängerbaustein E und der Isolator IS stapelförmig aufeinander angeordnet und miteinander kraftschlüssig verbunden, wobei der Senderbaustein S und der Empfängerbaustein E voneinander galvanisch getrennt jedoch miteinander optisch gekoppelt sind. Der Isolator IS ist zumindest für die Emissionswellenlängen des Senderbausteins S transparent. Die drei Bausteine S, IS und E sind derart angeordnet, dass die Schwerelinie der Oberfläche des Sendebereichs SF und die Schwerelinie der Oberfläche des Empfangsbereichs EF exakt zueinander parallel sind und die beiden Schwerelinien - nicht dargestellt- keinen Versatz aufweisen. Indem vorliegend die Oberflächen der drei Bausteine S, IS und E vorzugsweise quadratisch ausgebildet sind, durchstößt die jeweilige Schwerelinie, oder anders ausgedrückt die Normale an der Stelle des Flächenschwerpunkts, die jeweilige Oberfläche in deren Flächenmitte. Das Licht L des Senderbausteins S wirkt durch den Isolator IS unmittelbar auf den Empfängerbaustein E ein.

In der Ausschnittsvergrößerung ist der Empfangsbereich EF des Empfängerbausteins E detailliert dargestellt. In einer elektrotechnischen Betrachtung weist der Empfängerbaustein E eine Anzahl von vier zueinander in Serie geschalteten Teilspannungsquellen auf. Jede der Teilspannungsquellen umfasst eine Halbleiterdiode D1 bis D4. Die Dioden D1 bis D4 weisen einen nicht dargestellten p-n Übergang auf. Zwischen jeweils zwei aufeinanderfolgenden Teilspannungsquellen ist jeweils eine Tunneldiode TD1 bis TD3 angeordnet. Die Teilspannungsquellen und die Tunneldioden TD1 bis TD3 sind zusammen monolithisch integriert. Bei einer Bestrahlung durch den Senderbaustein S erzeugt der Empfängerbaustein E eine Gesamtspannung oberhalb von 2 V, wobei die einzelnen Dioden des Stapels nahezu eine identische Teilspannung erzeugen.

In der Abbildung der Figur 2 ist eine Querschnittsansicht auf eine zweite erfindungsgemäße Ausführungsform eines Optokopplerbausteins OPT dargestellt. Im Folgenden werden nur die Unterschiede zu der Ausführungsform dargestellt in der Abbildung der Figur 1 erläutert. Die Fläche des plattenförmigen Isolators IS ist größer als die Fläche des Senderbausteins S und die Fläche des Empfängerbausteins E, sodass der Isolator IS umlaufend balkonartig aus dem Stapel hervorsteht. Zwischen dem Isolator IS und dem Senderbaustein S einerseits und dem Isolator IS und dem Empfängerbaustein E sind jeweils eine transparente Verbindungsschicht KL ausgebildet. Mittels der Verbindungsschicht KL sind der Empfängerbaustein E und der Senderbaustein S kraftschlüssig mit dem Isolator IS zu einem Stapel verbunden.

In der Abbildung der Figur 3a ist eine Querschnittsansicht auf eine dritte erfindungsgemäße Ausführungsform eines Optokopplerbausteins OPT dargestellt. Im Folgenden werden nur die Unterschiede zu der Ausführungsform dargestellt in der Abbildung der Figur 1 und der Figur 2 erläutert. Der Senderbaustein S umfasst zusätzlich zu dem Sendebereich SF eine Substratschicht SUBS. Der Empfängerbaustein E umfasst zusätzlich zu dem Empfängerbereich EF eine Substratschicht SUBE. Beide Substratschichten SUBS und SUBE sind als Trägerschichten ausgebildet. Zwischen den beiden Substratschichten SUBS und SUBE ist der Sendebereich SF und der Empfangsbereich EF angeordnet. Auf der Oberseite und Unterseite des plattenförmigen Isolators IS ist jeweils die ebenfalls transparente Verbindungsschicht KL ausgebildet. Die Verbindungsschicht KL ist dünner als 0,2 mm, vorzugsweise dünner als 0,02 mm und verbindet die Oberseite des Isolators stoffschlüssig mit dem Sendebereich SF und die Unterseite des Isolators stoffschlüssig mit dem Empfangsbereich. Der Vorteil der Anordnung ist, dass das Licht L des Sendebereichs SF unmittelbar durch den Isolator IS auf den Empfangsbereich EF trifft.

In der Abbildung der Figur 3b ist eine Querschnittsansicht auf eine vierte erfindungsgemäße Ausführungsform eines Optokopplerbausteins OPT dargestellt. Im Folgenden werden nur die Unterschiede zu der Ausführungsform dargestellt in der Abbildung der Figur 3a erläutert. Zwischen dem Sendebereich SF und dem Isolator IS ist die Substratschicht SUBS und zwischen dem Empfarigsbereich EF und dem Isolator IS ist die Substratschicht SUBE angeordnet. Vorliegend durchläuft das Licht L zusätzlich zu dem Isolator auch die beiden Substratschichten SUBS und SUBE, um auf den Empfangsbereich EF absorbiert zu werden. Es versteht sich, dass die Substratschichten SUBS und SUBE eine geringe Absorption in dem Bereich der Emissionswellenlänge des Senderbausteins S aufweisen.

In der Abbildung der Fig. 4 ist eine Querschnittsansicht auf eine detaillierte Darstellung des Empfängerbausteins E als Teil des Optokopplerbaustein OPT dargestellt. Nachfolgend werden nur die Unterschiede zu der Ausführungsform der Figur 1 erläutert. Die Schichtdicken der Dioden D1 bis D4 nehmen mit dem Abstand der jeweiligen Diode von dem Isolator IS kontinuierlich zu, wobei die vierte Diode D4 die größte Schichtdicke aufweist.

In der Abbildung der Fig. 5 ist eine Querschnittsansicht auf eine gehäuste Ausführungsform eines Optokopplerbaustein OPT dargestellt. Nachfolgend werden nur die Unterschiede zu den vorangegangenen Ausführungsformen erläutert. Der Stapel aus Senderbaustein S und Isolator IS und Empfängerbaustein E sind in einem gemeinsamen Gehäuse G integriert. Der Senderbaustein S weist eine ersten elektrischen Anschlusskontakt KS1 und eine zweiten elektrischen Kontaktanschluss KS2 auf. Der Empfängerbaustein E weist einen ersten elektrischen Anschlusskontakt KE1 und einen zweiten elektrischen Anschlusskontakt KE2 auf.

## Patentansprüche

1. Stapelförmiger Optokopplerbaustein (OPT), aufweisend
- einen Senderbaustein (S) mit einem Sendebereich (SF), wobei der Sendebereich (SF) eine Oberfläche aufweist, und
einen Empfängerbaustein (E) mit einem Empfangsbereich (EF), wobei der Empfangsbereich (EF) eine Oberfläche aufweist, und
- einen plattenförmigen elektrischen Isolator (IS), und
- wobei der Isolator (IS) zwischen dem Senderbaustein (S) und dem Empfängerbaustein (E) ausgebildet ist, und
- der Senderbaustein (S) und der Empfängerbaustein (E) und der Isolator stapelförmig aufeinander angeordnet sind, und
- der Senderbaustein (S) und der Empfängerbaustein (E) voneinander galvanisch getrennt jedoch miteinander optisch gekoppelt sind, wobei der Isolator (IS) wenigstens für ein Teil der Emissionswellenlängen des Sendebereichs (SF) transparent ist, und
- die Schwerelinie der Oberfläche des Sendebereichs (SF) und die Schwerelinie der Oberfläche des Empfangsbereichs (EF) im Wesentlichen oder exakt zueinander parallel sind,
**dadurch gekennzeichnet, dass**
- der Versatz zwischen den beiden Schwerelinien kleiner als die Hälfte oder kleiner als ein Zehntel oder kleiner als ein fünfzigstel der Entfernung der jeweiligen Schwerelinien zu einer Außenkante der Oberfläche des Sendebereichs (SF) oder zu einer Außenkante der Oberfläche des Empfangsbereichs (EF) ist, so dass das Licht des Senderbausteins (S) überwiegend oder ausschließlich durch den Isolator (IS) auf den Empfängerbaustein (E) einwirkt, und
der Isolator (IS) auf allen Seiten aus dem Stapel balkonförmig hervorsteht, und
- der Empfängerbaustein (E) eine Anzahl N zueinander in Serie geschalteter Teilspannungsquellen aufweist, wobei N eine natürliche Zahl und ≥ 2 ist, und
- die Abweichung der Teilspannungen der einzelnen Tellspannungsquellen untereinander kleiner als 20% ist, und
- jede der Teilspannungsquellen eine Halbleiterdiode (D1,.. ,DN) mit einen p-n Übergang aufweist, und
- zwischen jeweils zwei aufeinanderfolgenden Teilspannungsquellen eine Tunneldiode (TD1, ,TDN-1) ausgebildet ist, wobei
- die Teilspannungsquellen und die Tunneldioden (TD1, ,TDN-1) zusammen monolithisch integriert sind, und
der Senderbaustein und der Empfängerbaustein ein III-V Material umfassen, und
der Unterschied zwischen der Größe der Oberfläche des Sendebereichs (SF) und der Größe der Oberfläche des Empfangsbereich (EF) kleiner als 20% ist.

2. Stapelförmiger Optokopplerbaustein (OPT) nach Anspruch 1, **dadurch gekennzeichnet, dass** die Oberfläche des Sendebereichs (SF) und die Oberfläche des Empfangsbereichs (EF) eine viereckige Form aufweisen und die größte Kantenlänge des jeweiligen Vierecks kleiner als 2 mm ist.

3. Stapelförmiger Optokopplerbaustein (OPT) nach Anspruch 1 oder Anspruch 2, **dadurch gekennzeichnet, dass** der Stapel aus Senderbaustein (S) und Isolator (IS) und Empfängerbaustein (E) in einem gemeinsamen Gehäuse (G) integriert sind.

4. Stapelförmiger Optokopplerbaustein (OPT) nach einem oder mehreren der vorangegangenen Ansprüche, **dadurch gekennzeichnet, dass** die Oberfläche des Sendebereichs (SF) und die Oberfläche des Empfangsbereichs (EF) gleich groß sind und dass mit Ausnahme von den elektrischen Anschlussbereichen der gesamte Sendebereich (SF) Licht (L) emittiert und der gesamte Empfangsbereich (EF) Licht (L) absorbiert.

5. Stapelförmiger Optokopplerbaustein (OPT) nach einem oder mehreren der vorangegangenen Ansprüche, **dadurch gekennzeichnet, dass** die Oberfläche des Sendebereichs (SF) und die Oberfläche des Empfangsbereichs (EF) quadratisch sind und jeweils eine Grundfläche größer als 0,2 x 0,2 mm² und kleiner als 4 mm² oder kleiner als 1 mm² aufweisen.

6. Stapelförmiger Optokopplerbaustein (OPT) nach einem der vorangegangenen Ansprüche, **dadurch gekennzeichnet, dass** der Senderbaustein (S) einen optischen Spiegel für die Wellenlänge des Senders oder eine RCLED oder einen oberflächenemittierenden Laser aufweist.

7. Stapelförmiger Optokopplerbaustein (OPT) nach einem oder mehreren der vorangegangenen Ansprüche, **dadurch gekennzeichnet, dass** der plattenförmige Isolator (IS) aus Kunststoff und oder aus Glas und oder aus Aluminiumdioxid und oder aus Epoxidharz und oder aus Silikon besteht.

8. Stapelförmiger Optokopplerbaustein (OPT) nach einem oder mehreren der vorangegangenen Ansprüche, **dadurch gekennzeichnet, dass** der Isolator (IS) auf allen Seiten aus dem Stapel um wenigstens 5 µm hervorsteht.

9. Stapelförmiger Optokopplerbaustein (OPT) nach einem oder mehreren der vorangegangenen Ansprüche, **dadurch gekennzeichnet, dass** die Dicke des Isolators (IS) kleiner als 0.5 mm mindestens jedoch 50 µm ist.

10. Stapelförmiger Optokopplerbaustein (OPT) nach einem oder mehreren der vorangegangenen Ansprüche, **dadurch gekennzeichnet, dass** die Emissionswellenlänge des Sendebereichs (SF) gleich oder um maximal 10 % kleiner als die Absorptionskante des Empfängerbereichs (EF) ist.

11. Stapelförmiger Optokopplerbaustein (OPT) nach einem oder mehreren der vorangegangenen Ansprüche, **dadurch gekennzeichnet, dass** der Senderbaustein (S) und der Empfängerbaustein (E) aus einem III-V Material ausgebildet sind.

12. Stapelförmiger Optokopplerbaustein (OPT) nach einem oder mehreren der vorangegangenen Ansprüche, **dadurch gekennzeichnet, dass** der Empfängerbaustein (E) ein GaAs und / oder ein Ge-Substrat umfasst.

13. Stapelförmiger Optokopplerbaustein (OPT) nach einem oder mehreren der vorangegangenen Ansprüche, **dadurch gekennzeichnet, dass** der Empfängerbaustein (E) ein (Al)GaAs und / oder ein InGaP und / oder ein InGaAs Material umfasst.

14. Stapelförmiger Optokopplerbaustein (OPT) nach einem oder mehreren der vorangegangenen Ansprüche, **dadurch gekennzeichnet, dass** der Empfängerbaustein (E) und der Senderbaustein (S) entlang der Stapelrichtung einen pyramidenstumpfartige Ausbildung aufweist, wobei der Unterschied zwischen der Flächengröße der Unterseite des Pyramidenstumpfs und der Oberseite des Pyramidenstumpfs wenigstens 5 µm² beträgt.

15. Stapelförmiger Optokopplerbaustein (OPT) nach einem oder mehreren der vorangegangenen Ansprüche, **dadurch gekennzeichnet, dass** die Oberfläche des Sendebereichs (SF) unmittelbar an der Oberseite des Isolators (IS) und die Oberfläche des Empfangsbereichs (EF) unmittelbar an der Unterseite des Isolators (IS) angeordnet sind, so dass die Oberfläche des Sendebereich (SF) und die Oberfläche des Empfangsbereich (EF) einander zugewandt sind.

16. Stapelförmiger Optokopplerbaustein (OPT) nach einem oder mehreren der Ansprüche 1 bis 15, **dadurch gekennzeichnet, dass** der Senderbaustein (S) eine Substratschicht (SUBS) aufweist und die Substratschicht (SUBS) an der Oberseite des Isolators (IS) angeordnet ist und der Empfängerbaustein (E) eine Substratschicht (SUBE) aufweist und die Substratschicht (SUBE) an der Unterseite des Isolators (IS) angeordnet ist, so dass die beiden Substratschichten (SUBS, SUBE) unmittelbar einander zugewandt sind.

## Claims

1. Stack-shaped optocoupler module (OPT), comprising
- a transmitter module (S) with a transmitting region (SF), wherein the transmitting region (SF) has a surface,
- a receiving module (E) with a receiving region (EF), wherein the receiving region (EF) has a surface,
- a plate-shaped electrical insulator (IS),
- wherein the insulator (IS) is formed between the transmitter module (S) and the receiver module (E),
- the transmitter module (S), the receiver module (E) and the insulator are arranged in stack shape one on the other,
- the transmitter module (S) and the receiver module (E) are electrically separated from one another, but optically connected together, wherein the insulator (IS) is transparent at least for a part of the emission wavelengths of the transmitting region (SF), and
- the median line of the surface of the transmitting region (SF) and the median line of the surface of the receiving region (EF) are arranged substantially or exactly parallel to one another,
**characterised in that**
- the offset between the two median lines is smaller than half or smaller than a tenth or smaller than a fifteenth of the spacing of the respective median lines from an outer edge of the surface of the transmitting region (SF) or from an outer edge of the surface of the receiving region (EF) so that the light of the transmitter module (S) acts on the receiver module (E) predominantly or exclusively through the insulator (IS),
- the insulator (IS) projects in balcony shape from the stack on all sides,
- the receiver module (E) comprises a number N of sub-voltage sources connected with one another in series, wherein N is a natural number and ≥ 2,
- the difference of the sub-voltages of the individual sub-voltage sources from one another is less than 20%,
- each of the sub-voltage sources comprises a semiconductor diode (D1, ..., DN) with a p-n transition,
- a tunnel diode (TD1, , TDN-1) is formed between each two successive sub-voltage sources, wherein
- the sub-voltage sources and the tunnel diodes (TD1, , TDN-1) are monolithically integrated together,
- the transmitter module and the receiver module comprise a III-V material, and
- the difference between the size of the surface of the transmitting region (SF) and the size of the surface of the receiving region (EF) is less than 20%.

2. Stack-shaped optocoupler module (OPT) according to claim 1, **characterised in that** the surface of the transmitting region (SF) and the surface of the receiving region (EF) has a quadrilateral shape and the largest edge length of the respective quadrilateral is less than 2 mm.

3. Stack-shaped optocoupler module (OPT) according to claim 1 or claim 2, **characterised in that** the stack consisting of transmitter module (S), insulator (IS) and receiver module (E) is integrated in a common housing (G).

4. Stack-shaped optocoupler module (OPT) according to one or more of the preceding claims, **characterised in that** the surface of the transmitting region (SF) and the surface of the receiving region (EF) are the same size and that with the exception of the electrical connecting regions the entire transmitting region (SF) emits light (L) and the entire receiving region (EF) absorbs light (L).

5. Stack-shaped optocoupler module (OPT) according to one or more of the preceding claims, **characterised in that** the surface of the transmitting region (SF) and the surface of the receiving region (EF) are quadrilateral and each have a base area larger than 0.2 x 0.2 mm² and smaller than 4 mm² or smaller than 1 mm².

6. Stack-shaped optocoupler module (OPT) according to any one of the preceding claims, **characterised in that** the transmitter module (S) comprises an optical mirror for the wavelength of the transmitter or an RCLED or a surface-emitting laser.

7. Stack-shaped optocoupler module (OPT) according to one or more of the preceding claims, **characterised in that** the plate-shaped insulator (IS) consists of plastics material and/or of glass and/or of aluminium dioxide and/or of epoxy resin and/or of silicon.

8. Stack-shaped optocoupler module (OPT) according to one or more of the preceding claims, **characterised in that** the insulator (IS) protrudes on all sides from the stack by at least 5 µm.

9. Stack-shaped optocoupler module (OPT) according to one or more of the preceding claims, **characterised in that** the thickness of the insulator (IS) is smaller than 0.5 mm, but at least 50 µm.

10. Stack-shaped optocoupler module (OPT) according to one or more of the preceding claims, **characterised in that** the emission wavelength of the transmitting region (SF) is the same as or smaller by at most 10% than the absorption edge of the receiving region (EF).

11. Stack-shaped optocoupler module (OPT) according to one or more of the preceding claims, **characterised in that** the transmitter module (S) and the receiver module (E) are formed from a III-V material.

12. Stack-shaped optocoupler module (OPT) according to one or more of the preceding claims, **characterised in that** the receiver module (E) comprises a GaAs and/or a Ge substrate.

13. Stack-shaped optocoupler module (OPT) according to one or more of the preceding claims, **characterised in that** the receiver module (E) comprises an (AI)GaAs and/or an InGaP and/or an InGaAs material.

14. Stack-shaped optocoupler module (OPT) according to one or more of the preceding claims, **characterised in that** the receiver module (E) and the transmitter module (S) have a frusto-pyramidal-shaped form along the stack direction, wherein the difference between the area size of the lower side of the frusto-pyramid and the upper side of the frusto-pyramid is at least 5 µm².

15. Stack-shaped optocoupler module (OPT) according to one or more of the preceding claims, **characterised in that** the surface of the transmitting region (SF) is arranged directly at the upper side of the insulator (IS) and the surface of the receiving region (EF) is arranged directly at the lower side of the insulator (IS) so that the surface of the transmitting region (SF) and the surface of the receiving region (EF) face one another.

16. Stack-shaped optocoupler module (OPT) according to one or more of claims 1 to 15, **characterised in that** the transmitter module (S) comprises a substrate layer (SUBS) and the substrate layer (SUBS) is arranged at the upper side of the insulator (IS) and the receiver module (E) has a substrate layer (SUBE) and the substrate layer (SUBE) is arranged at the lower side of the insulator (IS) so that the two substrate layers (SUBS, SUBE) directly face one another.

## Revendications

1. Module optocoupleur en forme d'empilement (OPT), comprenant :
- un module d'émetteur (S) comprenant une zone d'émission (SF), la zone d'émission (SF) présentant une surface, et
- un module de récepteur (E) comprenant une zone de réception (EF), la zone de réception (EF) présentant une surface, et
- un isolateur électrique (IS) en forme de plaque, et
- l'isolateur (IS) étant formé entre le module d'émetteur (S) et le module de récepteur (E), et
- le module d'émetteur (S) et le module de récepteur (E) et l'isolateur étant disposés les uns au-dessus des autres sous la forme d'un empilement, et
- le module d'émetteur (S) et le module de récepteur (E) étant séparés l'un de l'autre de manière galvanique mais étant couplés l'un à l'autre de manière optique, l'isolateur (IS) étant transparent au moins pour une partie des longueurs d'onde d'émission de la zone d'émission (SF), et
- la ligne de gravité de la surface de la zone d'émission (SF) et la ligne de gravité de la surface de la zone de réception (EF) étant sensiblement ou exactement parallèles l'une à l'autre,
**caractérisé en ce que** :
- le décalage entre les deux lignes de gravité est inférieur à la moitié ou inférieur à un dixième ou inférieur à un cinquantième de la distance entre les lignes de gravité respectives et un bord extérieur de la surface de la zone d'émission (SF) ou un bord extérieur de la surface de la zone de réception (EF), de telle sorte que la lumière du module d'émetteur (S) agisse majoritairement ou exclusivement par l'intermédiaire de l'isolateur (IS) sur le module de récepteur (E), et
l'isolateur (IS) fait saillie sous la forme d'un balcon de tous les côtés de l'empilement, et
- le module de récepteur (E) comprend un nombre N de sources de tension partielle qui sont connectées en série les unes aux autres, N étant un nombre naturel et étant supérieur ou égal à 2, et
- l'écart entre les tensions partielles de chaque source de tension partielle est inférieur à 20 %, et
- chacune des sources de tension partielle comprend une diode à semi-conducteur (D1, ..., DN) à jonction p-n, et
- une diode à effet tunnel (TD1, TDN-1) est formée entre deux sources de tension partielle successives,
- les sources de tension partielle et les diodes à effet tunnel (TD1, TDN-1) étant intégrées ensemble de manière monolithique, et
- le module d'émetteur et le module de récepteur comprennent un matériau III-V, et
- la différence entre la taille de la surface de la zone d'émission (SF) et la taille de la surface de la zone de réception (EF) est inférieure à 20 %.

2. Module optocoupleur en forme d'empilement (OPT) selon la revendication 1, **caractérisé en ce que** la surface de la zone d'émission (SF) et la surface de la zone de réception (EF) présentent une forme carrée, et la longueur d'arête la plus grande du carré respectif est inférieure à 2 mm.

3. Module optocoupleur en forme d'empilement (OPT) selon la revendication 1 ou la revendication 2, **caractérisé en ce que** l'empilement constitué du module d'émetteur (S) et de l'isolateur (IS) et du module de récepteur (E) est intégré dans un boîtier commun (G).

4. Module optocoupleur en forme d'empilement (OPT) selon l'une quelconque ou plusieurs des revendications précédentes, **caractérisé en ce que** la surface de la zone d'émission (SF) et la surface de la zone de réception (EF) sont égales, et **en ce que**, à l'exception des zones de connexion électrique, l'ensemble de la zone d'émission (SF) émet la lumière (L) et l'ensemble de la zone de réception (EF) absorbe la lumière (L).

5. Module optocoupleur en forme d'empilement (OPT) selon l'une quelconque ou plusieurs des revendications précédentes, **caractérisé en ce que** la surface de la zone d'émission (SF) et la surface de la zone de réception (EF) sont carrées et présentent respectivement une surface de base qui est supérieure à 0,2 x 0,2 mm² et qui est inférieure à 4 mm² ou inférieure à 1 mm².

6. Module optocoupleur en forme d'empilement (OPT) selon l'une quelconque des revendications précédentes, **caractérisé en ce que** le module d'émetteur (S) comprend un miroir optique pour la longueur d'onde de l'émetteur ou une RCLED ou un laser à émission de surface.

7. Module optocoupleur en forme d'empilement (OPT) selon l'une quelconque ou plusieurs des revendications précédentes, **caractérisé en ce que** l'isolateur (IS) en forme de plaque est constitué d'une matière plastique et ou de verre et ou de dioxyde d'aluminium et ou de résine époxy et ou de silicone.

8. Module optocoupleur en forme d'empilement (OPT) selon l'une quelconque ou plusieurs des revendications précédentes, **caractérisé en ce que** l'isolateur (IS) fait saillie d'au moins 5 µm de tous les côtés de l'empilement.

9. Module optocoupleur en forme d'empilement (OPT) selon l'une quelconque ou plusieurs des revendications précédentes, **caractérisé en ce que** l'épaisseur de l'isolateur (IS) est inférieure à 0,5 mm mais est au moins égale à 50 µm.

10. Module optocoupleur en forme d'empilement (OPT) selon l'une quelconque ou plusieurs des revendications précédentes, **caractérisé en ce que** la longueur d'onde d'émission de la zone d'émission (SF) est égale ou inférieure de 10 % au maximum au bord d'absorption de la zone de réception (EF).

11. Module optocoupleur en forme d'empilement (OPT) selon l'une quelconque ou plusieurs des revendications précédentes, **caractérisé en ce que** le module d'émetteur (S) et le module de récepteur (E) sont formés à partir d'un matériau III-V.

12. Module optocoupleur en forme d'empilement (OPT) selon l'une quelconque ou plusieurs des revendications précédentes, **caractérisé en ce que** le module de récepteur (E) comprend un GaAs et/ou un substrat de Ge.

13. Module optocoupleur en forme d'empilement (OPT) selon l'une quelconque ou plusieurs des revendications précédentes, **caractérisé en ce que** le module de récepteur (E) comprend un (Al)GaAs et/ou un InGaP et/ou un matériau InGaAs.

14. Module optocoupleur en forme d'empilement (OPT) selon l'une quelconque ou plusieurs des revendications précédentes, **caractérisé en ce que** le module de récepteur (E) et le module d'émetteur (S) présentent une configuration en forme de pyramide qui est tronquée le long de la direction d'empilement, la différence entre la superficie de la face inférieure de la pyramide tronquée et de la face supérieure de la pyramide tronquée étant égale à au moins 5 µm².

15. Module optocoupleur en forme d'empilement (OPT) selon l'une quelconque ou plusieurs des revendications précédentes, **caractérisé en ce que** la surface de la zone d'émission (SF) est disposée directement sur la face supérieure de l'isolateur (IS) et la surface de la zone de réception (EF) est disposée directement sur la face inférieure de l'isolateur (IS), de telle sorte que la surface de la zone d'émission (SF) et la surface de la zone de réception (EF) soient situées l'une en face de l'autre.

16. Module optocoupleur en forme d'empilement (OPT) selon l'une quelconque ou plusieurs des revendications 1 à 15, **caractérisé en ce que** le module d'émetteur (S) comprend une couche de substrat (SUBS) et la couche de substrat (SUBS) est disposée sur la face supérieure de l'isolateur (IS), et le module de récepteur (E) comprend une couche de substrat (SUBE) et la couche de substrat (SUBE) est disposée sur la face inférieure de l'isolateur (IS), de telle sorte que les deux couches de substrat (SUBS, SUBE) soient situées directement l'une en face de l'autre.
